# EUROPÄISCHE PATENTANMELDUNG

(11) **EP 1 775 543 A1**
(43) Veröffentlichungstag der Anmeldung: **18.04.2007**
(21) Anmeldenummer: 06017368.9
(22) Anmeldetag: 21.08.2006
(51) Int. Cl.: F41J 5/02

(54) **Zielscheibe**

(30) Priorität: 11.10.2005 DE 102005048649
(71) Anmelder: SCHOTT Solar GmbH, 63755 Alzenau (DE)
(72) Erfinder: Schillen, Mathias, 81669 München (DE)
(74) Vertreter: Haft, von Puttkamer, Berngruber

(57) **Zusammenfassung**

Eine Zielscheibe (1) für Laser-Zielvorrichtungen besteht aus Elementen (2 bis 5), die Kreissektoren bilden und mit einer photovoltaischen Schichtfolge (8) versehen sind, die durch elektrische Isolierlinien (11 bis 14) in teilringförmige Einzelfelder (16 bis 20) getrennt ist, die jeweils mit einem Anschluss (24; 26 bis 30) für den Photostrom versehen sind.

## Beschreibung

Die Erfindung bezieht sich auf eine Zielscheibe nach dem Oberbegriff des Anspruchs 1 sowie ein Verfahren zu deren Herstellung.

Im Schießsport und im professionellen Bereich, z.B. beim Militär, sowie im Freizeitbereich wird zunehmend anstelle eines Projektils mit einem Laserstrahl auf die Zielscheibe geschossen, die dazu aus lichtempfindlichen photovoltaischen Elementen (Sensorelementen) besteht.

So ist es bekannt, einzelne photovoltaische Elemente mosaikartig auf einer Leiterplatte zu einer solchen Zielscheibe zu verlöten. Eine derartige Zielscheibe ist jedoch aufwändig und kostspielig. Gleiches gilt für Zielscheiben, bei denen die einzelnen Elemente durch Belichtungsmasken entsprechend der klassischen Halbleiterherstellung gebildet sind, die zudem in der Größe beschränkt sind.

Ferner ist es bekannt, den Laserstrahl mit einem Parabolspiegel auf ein CMOS-Bauelement zu lenken, das zur Bildverarbeitung verwendet wird.

Aus DE 10 2004 011 905 A1 ist bereits eine Zielscheibe für Laserzielvorrichtungen bekannt, um einen Schuss mit einer Schusswaffe zu simulieren. Die bekannte Zielscheibe besteht aus verschiedenartig geformten photovoltaischen Elementen, z.B. aus einem inneren Element, das von einem äußeren ringförmigen Element umgeben ist, wobei jedes der Elemente mit einem Photostromanschluss versehen ist. Die bekannte Zielscheibe hat den Nachteil, dass der Treffpunkt nur ungenau angegeben werden kann. Zudem ist die Größe der Zielscheibe beschränkt, da, wenn die Wegstrecke vom Treffpunkt zu den Anschlüssen zu groß wird, das elektrische Signal durch den elektrischen Widerstand nicht mehr erkennbar ist.

Aufgabe der Erfindung ist es, eine Zielscheibe bereitzustellen, die eine genaue Lokalisierung des Treffpunktes erlaubt, groß bzw. groß genug ausgebildet werden kann und mit geringen Herstellungskosten verbunden ist.

Dies wird erfindungsgemäß mit der im Anspruch 1 gekennzeichneten Zielscheibe erreicht. In den Ansprüchen 2 bis 8 sind vorteilhafte Ausgestaltungen der erfindungsgemäßen Zielscheibe wiedergegeben. Der Anspruch 9 hat ein bevorzugtes Verfahren zur Herstellung der erfindungsgemäßen Zielscheibe zum Gegenstand, welches nach den Ansprüchen 10 und 11 in vorteilhafter Weise ausgebildet werden kann.

Nach dem erfindungsgemäßen Verfahren ist die Zielscheibe aus Elementen zusammengesetzt, die Kreissektoren bilden, deren photovoltaische Schichtfolge durch elektrische Isolierlinien in teilringförmige Einzelfelder getrennt ist, die jeweils mit einem Anschluss für den Photostrom versehen sind. Die Elemente besitzen elektrische Isolierlinien mit gleichen Radien. Damit wird eine Zielscheibe gebildet, bei der die teilringförmigen Einzelfelder ringförmig angeordnet sind.

Durch die kleinen teilringförmigen Einzelfelder kann der Treffpunkt entsprechend genau lokalisiert werden. Da die Einzelfelder eine geringe Größe aufweisen, wird zudem ein deutlich erkennbarer Stromimpuls erzeugt.

Die erfindungsgemäße Zielscheibe kann rechteckig, insbesondere quadratisch, ausgebildet sein, wobei die sektorförmigen Elemente aus vier Quadranten bestehen. Jedoch ist auch jede andere Form der Elemente möglich. Wesentlich ist nur, dass jedes Element zwei Seiten aufweist, die den beiden Radien entsprechen, durch die das Kreissegment definiert wird, aus denen die Zielscheibe zusammengesetzt ist.

Da die erfindungsgemäße Zielscheibe aus mehreren Elementen zusammengesetzt ist, kann sie entsprechend groß ausgebildet werden.

Die photovoltaische Schichtfolge ist vorzugsweise auf ein elektrisch isolierendes, transparentes Substrat aufgebracht, z.B. Glas, welches an der Vorderseite der Zielscheibe angeordnet ist, also der Seite, auf die der Laserstrahl auftrifft. Die photovoltaische Schichtfolge weist vorzugsweise eine dem Substrat zugewandte vordere transparente Elektrodenschicht, z.B. aus einem transparenten elektrisch leitenden Metalloxid, die sogenannte TCO-Schicht, auf, ferner eine daran anschließende photovoltaische Halbleiterschicht und eine Elektrodenschicht, z.B. aus Metall, an der Rückseite der Halbleiterschicht.

Aufgrund ihrer kostengünstigen Herstellung werden vorzugsweise amorphe Silizium-Halbleiterschichten verwendet. Die amorphe Siliziumschicht kann auf die transparente Elektrodenschicht auf dem Substrat nacheinander als p-leitende, intrinsische, also undotierte, und n-leitende Schicht in dieser Reihenfolge abgeschieden werden (PIN-Diode). Auch ist eine Abscheidung auf der metallischen Elektrodenschicht in umgekehrter Reihenfolge möglich (NIP-Diode). In diesem Fall besteht das Substrat z.B. aus einer Metallfolie bzw. einem metallischen Glassubstrat (Rückkontakt). Als vordere Elektrode dient eine auf der p-Schicht aufgebrachte TCO-Elektrode.

Die elektrischen Isolierlinien, durch die die teilringförmigen Einzelfelder auf den Elementen der erfindungsgemäßen Zielscheibe gebildet werden, können durch Ausnehmungen gebildet werden, die beispielsweise auf chemischem Weg, also z.B. durch Ätzen, erzeugt werden können. Vorzugsweise werden die elektrisch isolierenden Ausnehmungen jedoch mit einem Laserstrahl erzeugt.

Die elektrisch isolierenden Ausnehmungen erstrecken sich vorzugsweise durch eine der beiden Elektrodenschichten, insbesondere die hintere metallische Elektrodenschicht, sowie durch die Halbleiterschicht.

Die Elektrodenschicht der teilringförmigen Einzelfelder, die durch die Ausnehmungen voneinander getrennt sind, werden jeweils mit einem Anschluss versehen, der, wenn eine PIN-Halbleiterschicht verwendet wird, den Minuspol bildet, während die vordere transparente Elektrodenschicht, die keine Ausnehmungen aufweist, also durchgehend elektrisch leitfähig ist, mit dem Anschluss für den Plus-Pol versehen wird. Um anzuzeigen, auf welches Einzelfeld der Laserstrahl trifft, wird über die Anschlüsse eine Anzeigeeinrichtung angesteuert.

Zur Herstellung der erfindungsgemäßen Zielscheibe wird eine Platte, die ein Vielfaches der Größe eines Elements besitzt, in Felder geteilt, die jeweils einem Kreissektor der Zielscheibe entsprechen, worauf die photovoltaische Schicht jedes Feldes durch elektrische Isolierlinien in teilringförmige Einzelfelder getrennt wird. Anschließend wird die Platte entsprechend den Feldern in einzelne Elemente zerteilt.

D.h., es kann beispielsweise eine Glasplatte von 60 x 60 cm und größer mit einer TCO-Schicht versehen werden, auf der dann z.B. eine amorphe Silizium-Halbleiterschicht in Form einer PIN-Diode abgeschieden wird, worauf die metallische Elektrodenschicht auf die Halbleiterschicht aufgebracht wird. Anschließend wird die Platte in beispielsweise quadratische Felder geteilt, worauf jedes quadratische Feld z.B. durch einen Laserstrahl mit elektrischen Isolierlinien in Form von Ausnehmungen versehen wird, um die teilringförmigen Einzelfelder zu bilden. Anschließend wird die Platte in die einzelnen Elemente zerteilt, um die Kreissektoren mit den teilringförmigen Einzelfeldern zu erhalten, aus denen dann die erfindungsgemäßen Zielscheiben zusammengesetzt werden.

Ein wesentlicher Vorteil der erfindungsgemäßen Ausführung ist, dass vor dem Zusammensetzen jedes der Einzelelemente getrennt auf Fehlerfreiheit getestet werden kann. So kann bei der Laserbehandlung zur Erzeugung der Ausnehmungen z.B. ein Kurzschluss auftreten, wenn die metallische Elektrodenschicht mit der TCO-Schicht in Berührung kommt. Nach dem erfindungsgemäßen Verfahren braucht dann nur das betreffende fehlerhafte Element verworfen zu werden. Dies ist erfindungsgemäß auch deswegen von Bedeutung, weil die Zielscheibe eine Vielzahl von durch elektrische Isolierlinien bzw. Ausnehmungen getrennte Einzelfelder aufweist und damit eine gewisse Wahrscheinlichkeit fehlerhafter Isolierlinien bzw. Ausnehmungen entsprechend gegeben ist.

Die erfindungsgemäße Zielscheibe ist insbesondere zum Laserschießen als Ersatz für scharfe Munition für den Schießsport, im professionellen Bereich, z.B. beim Militär oder bei der Polizei, sowie im Freizeitbereich geeignet. Mit der Laserzielvorrichtung wird dabei ein Schuss mit einer Schusswaffe simuliert. Die erfindungsgemäße Zielscheibe kann jedoch auch als Positionierungssensorik für weit entfernte Ziele verwendet werden, beispielsweise zur Lagevermessung z.B. von Gebäuden oder Brückenschwingungen.

Nachstehend ist die Erfindung anhand der beigefügten Zeichnung beispielhaft näher erläutert. Darin zeigen:
- Figur 1: eine Draufsicht auf eine Zielscheibe;
- Figur 2: eine Draufsicht auf eines der Elemente, aus der die Zielscheibe nach Figur 1 zusammengesetzt ist;
- Figur 3: in schematischer Darstellung einen Schnitt durch das Element entlang der Linie III-III in Figur 2; und
- Figur 4: eine Draufsicht auf eine Platte, aus der die Elemente gemäß Figur 2 und 3 hergestellt werden.

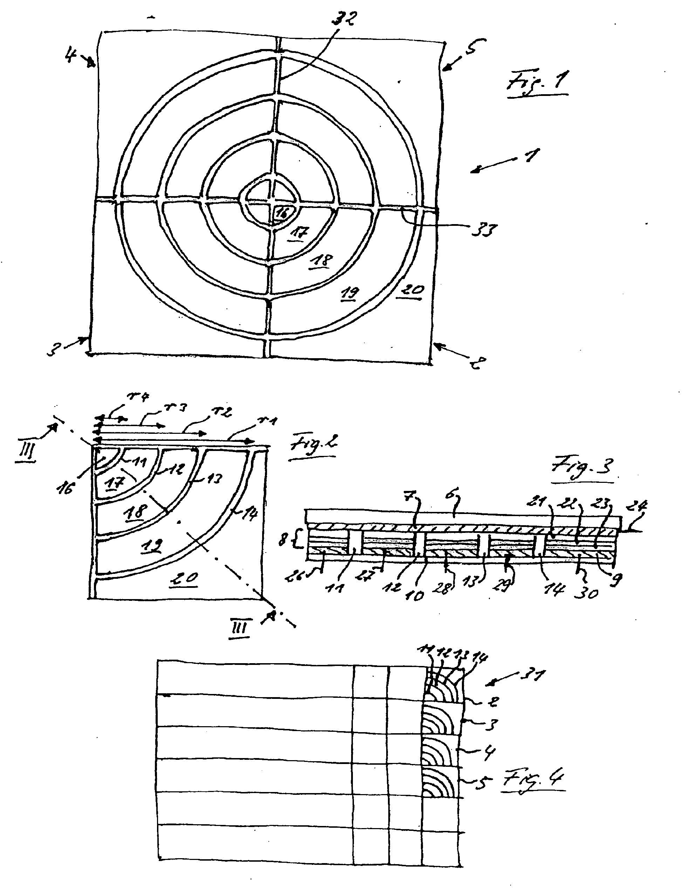

Gemäß Figur 1 ist die Zielscheibe 1 aus vier plattenförmigen Elementen 2 bis 5 zusammengesetzt. Jedes Element 2 bis 5 stellt einen Kreissektor der Zielscheibe 1 dar. Die Zielscheibe 1 ist quadratisch ausgebildet. Jedes Element 2 bis 5 bildet damit einen quadratischen Quadranten.

Wie in Figur 3 anhand des Elements 2 dargestellt, besteht jedes Element 2 bis 5 aus einem Glassubstrat 6 an der Vorderseite, einer transparenten Elektrodenschicht 7, einer Halbleiterschicht 8, einer metallischen Elektrodenschicht 9 und gegebenenfalls einer Schutzfolie 10 an der Rückseite. Die Elektrodenschicht 7, die Halbleiterschicht 8 und die Elektrodenschicht 9 stellen die photovoltaische Schichtfolge dar.

Jedes Element 2 bis 5 ist, wie anhand des Elements 2 in Figur 2 dargestellt, mit vier teilkreisförmigen elektrischen Isolierlinien 11 bis 14 versehen, wodurch fünf teilringförmige Einzelfelder 16 bis 20 entstehen. Die Isolierlinien 11 bis 14 weisen die Radien r1, r2, r3 und r4 auf.

Die Halbleiterschicht 8 ist gemäß Figur 3 als PIN-Diode aufgebaut. D.h., sie setzt sich aus drei Einzelschichten 21, 22 und 23 zusammen, die aus amorphem Silizium bestehen. Die Schicht 21 bildet dabei die p-leitende Schicht, die Schicht 22 die intrinsische Schicht und die Schicht 23 die n-leitende Schicht.

An die transparente Elektrodenschicht 7, die den Plus-Pol bildet, ist der Anschluss 24 gebondet.

Die elektrischen Isolierlinien 11 bis 14 werden gemäß Figur 3 durch Ausnehmungen gebildet, die mit einem Laserstrahl erzeugt worden sind, und zwar bevor die Schutzfolie 10 aufgebracht wird. Die Ausnehmungen 11 bis 14 erstrecken sich jeweils durch die metallische Elektrodenschicht 9 und die Halbleiterschicht 8. An die so gebildeten Abschnitte der metallischen Elektrodenschicht 9, die den Einzelfeldern 16 bis 20 entsprechen und den Minus-Pol bildem, ist jeweils ein Anschluss 26 bis 30 gebondet.

Gemäß Figur 4 stammen die Elemente 2 bis 5 von einer großflächigen Platte 31, auf der Elemente für mehrere (viele) Zielscheiben hergestellt werden können. Die Platte 31 besteht aus einer entsprechenden Glasplatte, auf die vollflächig die transparente Elektrodenschicht 7, die Halbleiterschicht 8 und die metallische Elektrodenschicht 9 aufgebracht worden sind (vgl. Figur 3) .

Die Platte 31 wird anschließend in quadratische Felder 2, 3, 4, 5, ... eingeteilt, in die mit einem Laserstrahl die Ausnehmungen 11 bis 14 gebrannt werden. Anschließend wird die Platte 31 so zerteilt, dass aus den quadratischen Feldern 2, 3, 4, 5, ... die quadratischen Elemente 2 bis 5 gebildet werden, aus denen die Zielscheibe 1 zusammengesetzt wird. Die Schutzfolie 10 kann vor oder nach dem Zerteilen der Platte angebracht werden, ebenso die Anschlüsse 24 sowie 26 bis 30.

Wenn die Zielscheibe 1 gemäß Figur 1 zusammengesetzt ist, sind die teilringförmigen Einzelfelder 16 bis 20 ringförmig angeordnet, wobei die senkrechte Isolierlinie 32 und die waagerechte Isolierlinie 33 die Einzelfelder 16 bis 20 zusammen mit den Isolierlinien 11 bis 14 unterteilen.

## Patentansprüche

1. Zielscheibe für Laser-Zielvorrichtungen, die aus plattenförmigen Elementen (2 bis 5) mit einer photovoltaischen Schicht besteht, die mit Anschlüssen (24; 26 bis 30) für den Photostrom versehen sind, **dadurch gekennzeichnet, dass** die Zielscheibe (1) aus Elementen (2 bis 5) besteht, die Kreissektoren bilden, deren photovoltaische Schichtfolge durch elektrische Isolierlinien (11 bis 14) in teilringförmige Einzelfelder (16 bis 20) getrennt ist, die jeweils mit einem Anschluss (24; 26 bis 30) für den Photostrom versehen sind, wobei die elektrischen Isolierlinien (11 bis 14) der Elemente (2 bis 5) gleiche Radien (r1 bis r4) zur Bildung einer Zielscheibe (1) besitzen, bei der die teilringförmigen Einzelfelder (16 bis 20) ringförmig angeordnet sind.

2. Zielscheibe nach Anspruch 1, **dadurch gekennzeichnet, dass** die Kreissektoren Quadranten bilden.

3. Zielscheibe nach Anspruch 2, **dadurch gekennzeichnet, dass** sie quadratisch ausgebildet ist und aus quadratischen Elementen (2 bis 5) besteht.

4. Zielscheibe nach einem der vorstehenden Ansprüche, **dadurch gekennzeichnet, dass** die photovoltaische Schichtfolge aus einer transparenten vorderen Elektrodenschicht (7), einer Halbleiterschicht (8) und einer hinteren Elektrodenschicht (9) besteht.

5. Zielscheibe nach Anspruch 1 und 4, **dadurch gekennzeichnet, dass** die elektrischen Isolierlinien (11 bis 14) durch Ausnehmungen wenigstens einer Elektrodenschicht (9) und der Halbleiterschicht (8) gebildet sind.

6. Zielscheibe nach Anspruch 5, **dadurch gekennzeichnet, dass** die Ausnehmungen an einer Elektrodenschicht (9) vorgesehen sind und jeder Abschnitt dieser Elektrodenschicht (9) mit jeweils einem Anschluss (26 bis 30) und die andere Elektrodenschicht (7) mit wenigstens einem Anschluss (24) für den Photostrom versehen ist.

7. Zielscheibe nach Anspruch 4, **dadurch gekennzeichnet, dass** die Halbleiterschicht (8) aus einer p-leitenden Schicht (21), einer intrinsischen Schicht (22) und einer n-leitenden Schicht (23) besteht.

8. Zielscheibe nach Anspruch 4 oder 7, **dadurch gekennzeichnet, dass** die Halbleiterschicht (8) eine amorphe Siliziumschicht ist.

9. Zielscheibe nach Anspruch 4 sowie 7 oder 8, **dadurch gekennzeichnet, dass** die Halbleiterschicht (8) durch Abscheidung der p-leitenden Schicht (21) an der transparenten Elektrodenschicht (7) und dann der intrinsischen Schicht (22) und der n-leitenden Schicht (23) gebildet ist (PIN-Diode) oder durch Abscheidung der n-leitenden Schicht (23) an der hinteren Elektrodenschicht (9) und dann der intrinsischen Schicht (22) und der p-leitenden Schicht (21) (NIP-Diode).

10. Verfahren zur Herstellung der Zielscheibe nach einem der vorstehenden Ansprüche, **dadurch gekennzeichnet, dass** eine Platte (31), die ein Vielfaches der Größe der Zielscheibe (1) aufweist, in Felder geteilt wird, die jeweils einem Kreissektor (2 bis 5) der Zielscheibe (1) entsprechen, die photovoltaische Schicht (8) jedes Feldes durch elektrische Isolierlinien (11 bis 14) in teilringförmige Einzelfelder (16 bis 20) getrennt und die Platte (31) entsprechend der Felder in die einzelnen Elemente (2 bis 5) zerteilt wird.

11. Verfahren nach Anspruch 10, **dadurch gekennzeichnet, dass** die elektrischen Isolierlinien (11 bis 14) durch Ausnehmungen gebildet werden.

12. Verfahren nach Anspruch 11, **dadurch gekennzeichnet, dass** die Ausnehmungen durch einen Laserstrahl erzeugt werden.
